Europäisches Patentamt

European Patent Office

Office européen des brevets

(19)

(11) **EP 1 208 244 B1**

(12) **EUROPÄISCHE PATENTSCHRIFT**

(45) Veröffentlichungstag und Bekanntmachung des Hinweises auf die Patenterteilung:
**12.05.2004 Patentblatt 2004/20**

(21) Anmeldenummer: **00912365.4**

(22) Anmeldetag: **07.02.2000**

(51) Int Cl.⁷: **C22C 19/00**, C22F 1/10

(86) Internationale Anmeldenummer:
**PCT/DE2000/000404**

(87) Internationale Veröffentlichungsnummer:
**WO 2000/060132 (12.10.2000 Gazette 2000/41)**

(54) **METALLISCHER WERKSTOFF AUF NICKELBASIS UND VERFAHREN ZU DESSEN HERSTELLUNG**

NICKEL-BASED METALLIC MATERIAL AND METHOD FOR PRODUCING SAME

MATERIAU METALLIQUE A BASE DE NICKEL ET SON PROCEDE DE PRODUCTION

(84) Benannte Vertragsstaaten:
**AT BE CH CY DE DK ES FI FR GB GR IE IT LI LU MC NL PT SE**

(30) Priorität: **03.04.1999 DE 19915317**

(43) Veröffentlichungstag der Anmeldung:
**29.05.2002 Patentblatt 2002/22**

(73) Patentinhaber: **Leibniz-Institut für Festkörper- und Werkstoffforschung Dresden e.V. 01069 Dresden (DE)**

(72) Erfinder:
• **EICKEMEYER, Jörg**
**D-01279 Dresden (DE)**

• **SELBMANN, Dietmar**
**D-01738 Colmnitz (DE)**
• **OPITZ, Ralph**
**D-01108 Dresden (DE)**
• **HOLZAPFEL, Bernhard**
**D-01731 Kreischa (DE)**

(74) Vertreter: **Rauschenbach, Dieter et al Rauschenbach Patentanwälte Postfach 27 01 75 01172 Dresden (DE)**

(56) Entgegenhaltungen:
| | |
|---|---|
| EP-A- 0 889 488 | DE-A- 2 225 020 |
| US-A- 4 948 434 | US-A- 5 500 057 |
| US-A- 5 783 145 | US-A- 5 788 783 |

EP 1 208 244 B1

**Beschreibung**

Technisches Gebiet

Die Erfindung betrifft einen metallischen Werkstoff auf Nickelbasis und ein Verfahren zu dessen Herstellung. Der Werkstoff ist beispielsweise einsetzbar als Unterlage für physikalisch-chemische Beschichtungen mit hochgradiger mikrostruktureller Ausrichtung. Solche Unterlagen sind zum Beispiel als Substrate für keramische Beschichtungen geeignet, wie sie auf dem Gebiet der Hochtemperatur-Supraleitung angewendet werden. Der Einsatz erfolgt in diesem Fall in supraleitenden Magneten, Transformatoren, Motoren, Tomographen oder supraleitenden Strombahnen.

Stand der Technik

Bekannt ist, dass polykristalline Metalle mit kubischflächenzentriertem Gitter, wie Nickel, Kupfer und Aluminium, nach vorausgegangener starker Kaltumformung durch Walzen bei der nachfolgenden Rekristallisation eine ausgeprägte Textur mit Würfellage ausbilden können (G. Wassermann: Texturen metallischer Werkstoffe, Springer, Berlin, 1939). Auf diese Weise texturierte Metallbänder, insbesondere Nickelbänder, werden auch als Unterlage für metallische Überzüge, keramische Pufferschichten und keramische Supraleiterschichten benutzt (A. Goyal et al.: US Patent 5 741 377, Apr.21,1998). Die Eignung solcher Metallbänder als Substratwerkstoff hängt maßgeblich vom erreichbaren Grad der Texturierung und der Stabilität der Textur im Bereich der Temperaturen ab, bei denen die Beschichtungsverfahren arbeiten. US-A-4 948 434 offenbart eine Legierung bestehend aus 76-81 gew.% ickel, 3-5 Gew.% Molybdän, 1.5-3.0 Gew.% Kupfer, 0.0015-0.0050 Gew.% Bor und den Rest Eisen. US-A-5 783 145 offenbart eine Eisen-Nickel-Legierung, die bis zu 4 Gew.% Mo + W + Cu enthalten kann. Bekannt ist auch, dass durch Legieren reiner Metalle mit anderen metallischen Elementen die Rekristallisationstemperaturen angehoben werden können. Zugleich nimmt aber der Grad der Würfeltextur mit wachsendem Legierungsgehalt stark ab, und das insbesondere bereits im Bereich kleiner gelöster Gehalte (R. E. Smallman: Journ. Inst. Metals 84(1955-56)10-18). Beispielsweise gilt für Aluminium, dass mit zunehmendem Eisengehalt im Bereich von 10 bis 300 ppm die Rekristallisationstemperatur zunehmend angehoben wird, die Würfeltextur hingegen deutlich schwächer wird (W. B. Hutchinson, H.-E. Ekström: Mater. Sci. Technol. 6(1990)1103-1111). Ein sehr starker negativer Einfluß von Magnesium auf die Texturierbarkeit von Nickel wurde ebenfalls nachgewiesen (K. Detert u.a.: Z. Metallkde. 54(1963)263-270). Es genügen 600 Atom-ppm, um die Herausbildung der Würfeltextur zu verhindern. Hinsichtlich der Erhöhung der Rekristallisationstemperatur des Nickels sind ebenfalls Elementwirkungen nachgewiesen (K. Detert, G.

Dressler: Acta Metall. 13(1965)845-853). Das trifft zum Beispiel für Chrom und Molybdän als Legierungselemente zu. Andererseits ist deren spezifische Wirkung auf die Schärfe und die thermische Stabilität der Glühtextur, insbesondere für Gehalte ihrer Löslichkeit im Nickel, nicht klar. Es wurde gefunden, dass bei 3 Atom-% Molybdän eine Würfeltextur nicht mehr erzielbar ist (K. Detert u.a.: Z. Metallkde. 54(1963)263-270).

Beim Nickel ist davon auszugehen, dass weniger als 100 ppm Fremdelementgehalt zu gewährleisten sind, damit das eigentliche Nickelverhalten beobachtet werden kann (E. D. Specht et al.: Supercond. Sci. Technol. 11(1998)945-949). Bei höheren Gehalten ist zu erwarten, dass die primäre Rekristallisationstextur des Nickels als Würfeltextur weniger vollständig ausgebildet wird. Darüber hinaus ist bei höheren Temperaturen mit einem Abbau der primär gewachsenen Würfeltextur durch sekundäre Rekristallisationsvorgänge zu rechnen (R. E. Smallman, C. S. Lee: Mater. Sci. Eng. A184(1994)97-112). Solche höheren Temperaturen werden mit 700°C bis 800°C bei den üblichen Beschichtungsbedingungen, wie sie beim Abscheiden supraleitender Schichten vorliegen, erreicht.

Eine allgemeingültige Theorie über die Wirkungen von Legierungselementen auf die Ausbildung der Umform- und Glühtexturen der Metalle, bzw. im besonderen des Nickels, gibt es nicht.

Darstellung der Erfindung

Der Erfindung liegt die Aufgabe zu Grunde, einen metallischen Werkstoff auf Nickelbasis zu entwickeln, der im Vergleich zu technisch reinem Nickel eine höhergradige und thermisch stabilere Würfeltextur aufweist. Eingeschlossen in diese Aufgabe ist die Entwicklung eines Verfahrens zur Herstellung dieses Werkstoffs.

Diese Aufgabe wird mit einem metallischem Werkstoff gelöst, der erfindungsgemäß eine Rekristallisationswürfeltextur aufweist und aus einer Nickellegierung besteht, deren Zusammensetzung der allgemeinen Formel

$$Ni_a\,(Mo_b,W_c)_d\,M_e$$

entspricht, worin M für V, Cr und/oder Cu steht, mit

$$a = 100 - (d + e)$$

$$(d + e) \leq 50$$

$$b = 0 - 12$$

$$c = 0 - 12$$

$$d = (b + c) = 0,01 - 12$$

$$e = 0 - 49,9$$

- jeweils in Atom-% -

und mit gegebenenfalls enthaltenen geringen herstellungstechnisch bedingten Verunreinigungen.

Vorzugsweise liegt der Gesamtgehalt an Mo und/oder W im Bereich von 0,01 Atom-% bis 0,3 Atom-% oder im Bereich von 3 Atom-% bis 12 Atom-%.

Besonders vorteilhafte Eigenschaften werden erhalten, wenn der Werkstoff aus technisch reinem Ni und einem Mo- und/oder W-Gehalt von 0,1 Atom-% oder 5 Atom-% oder 10 Atom-% besteht.

Zur Herstellung des erfindungsgemäßen Werkstoffs wird zunächst auf schmelzmetallurgischem oder pulvermetallurgischem Wege oder durch mechanisches Legieren eine Legierung hergestellt, deren Zusammensetzung der allgemeinen Formel

$$Ni_a (Mo_b, W_c)_d M_e$$

entspricht, worin M für V, Cr und/oder Cu steht, mit

$$a = 100 - (d + e)$$

$$(d + e) \leq 50$$

$$b = 0 - 12$$

$$c = 0 - 12$$

$$d = (b + c) = 0,01 - 12$$

$$e = 0 - 49,9$$

- jeweils in Atom-% -

und mit gegebenenfalls enthaltenen geringen herstellungstechnisch bedingten Verunreinigungen. Diese Legierung wird mit einer Warmumformung sowie mit einer nachfolgenden hochgradigen Kaltumformung mit mehr als 80% Dickenreduktion zu Band verarbeitet und schließlich in reduzierender oder nichtoxidierender Atmosphäre einer rekristallisierenden Glühung zur Erzielung der Würfeltextur unterworfen.

Die schmelzmetallurgische Herstellung der Legierung erfolgt vorzugsweise durch Gießen in eine Kupferkokille.

Eine pulvermetallurgische Herstellung der Legierung kann vorzugsweise durch Kalt- und/oder Heißpressen unter isostatischen Bedingungen erfolgen.

Die hochgradige Kaltumformung wird zweckmäßigerweise mittels Walzen ausgeführt. Vorteilhaft sind Walzgrade mit mehr als 80% Dickenreduktion, vorzugsweise mit mehr als. 98%.

Die rekristallisierende Glühung wird erfindungsgemäß bei Temperaturen im Bereich von 350°C bis 1150°C ausgeführt.

Durch das Mikrolegieren von technisch reinem Nickel mit Mo und/oder W wird der relative Texturgrad der Würfellage nach Kaltwalzen und Glühen um 10 bis 25% gesteigert. Gleichzeitig wird die Glühtextur gegenüber dem technisch reinen Nickel, in dem sie nur bis etwa 600°C stabil bleibt, thermisch stabilisiert und bleibt bis über 1100°C erhalten.

Diese Wirkungen der beiden Mikrolegierungselemente Mo und/oder W sind für die Anwendungseigenschaften der texturierten Materialien besonders vorteilhaft, da die Nickelsubstrate unter den Bedingungen der Beschichtung mit Puffer- und/oder Supraleitermaterial strukturell unverändert bleibt, thermisch stabilisiert und bleibt bis über 1100°C erhalten.

Diese Wirkungen der beiden Mikrolegierungselemente Mo und/oder W sind für die Anwendungseigenschaften der texturierten Materialien besonders vorteilhaft, da die Nickelsubstrate unter den Bedingungen der Beschichtung mit Puffer- und/oder Supraleitermaterial strukturell unverändert bleiben. Ein epitaktisches bzw. quasiepitaktisches Aufwachsen der abgeschiedenen Substanzen wird von der Unterlage während des Prozesses somit nicht gestört.

In überraschender Weise zeigen die mit Mo und/oder W höherlegierten erfindungsgemäßen Nickelwerkstoffe ebenfalls vorteilhafte Wirkungen. Mit Gehalten von zum Beispiel 5 Atom% Mo oder W entstehen bei Glühtemperaturen oberhalb von 900°C hochgradige Würfeltexturen. Für die Anwendung solcher Substratlegierungen ergibt sich damit die Möglichkeit, unmagnetische Bänder herzustellen, da beide Elemente die Curie-Temperatur stark herabsetzen. Hierin liegt ein spezieller Vorteil für verlustarme Wechselstromanwendunge.: von Supraleitern. Darüber hinaus ist damit gleichzeitig eine vorteilhafte Mischkristallhärtung verbunden, die den Substraten eine 2- bis 3-fache Festigkeit bringt.

Auch eine pulvermetallurgische Herstellung über kalt- und heißisostatisches Pressen kann für das Ausgangsmaterial alternativ zur schmelzmetallurgischen Herstellung zweckmäßig sein.

Die metallurgisch hergestellten Guss- oder Presskörper können durch Warmumformung eine kontrollierte Einstellung der Korngröße sowie durch eine Homogenisierungsglühung ein vorteilhaftes Ausgangsgefüge für die Kaltumformung erhalten. Der Warmumformgrad, wie auch die Temperatur und Dauer der Glühung können leicht vom Fachmann unter dem Aspekt der guten Kaltumformbarkeit optimiert werden. Die Glühatmosphäre für die Rekristallisation ist zweckmäßigerweise reduzierend oder inert. Die Glühtemperaturen und -zeiten tendieren mit zunehmendem Legierungsgehalt zu höheren Werten und können unproblematisch vom Fachmann eingestellt werden.

Die Erfindung ist nachstehend anhand von Beispielen und zugehörigen Zeichnungen näher erläutert.

Kurze Beschreibung der Zeichnungen

Fig. 1:   Polfiguren der Würfeltextur von Nickel mit 0,1 Atom-% Wolfram nach Kaltwalzung und Rekristallisation bei 800°C,

Fig. 2:   ein Diagramm zum Einfluss der Glühtemperatur auf die Ausbildung der Würfeltextur für Ni und für Ni mit 0,1 Atom-% Mo oder W,

Fig. 3:   ein Diagramm zum Einfluss der Glühtemperatur auf die Ausbildung der Würfeltextur für Ni und für Ni mit unterschiedlichen Mo-Gehalten,

Fig. 4:   ein Diagramm zum Einfluss der Glühtemperatur auf die Ausbildung der Würfeltextur für Ni und für Ni mit unterschiedlichen W-Gehalten.

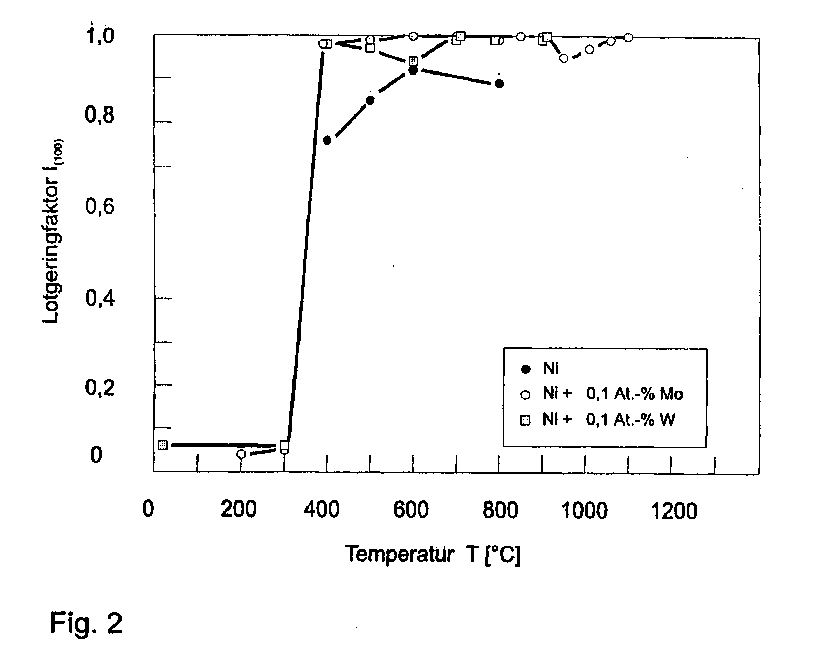

In den Figuren 2 bis 4 wird an Stelle von Polfiguren der Lotgeringfaktor $I_{(100)}$ zur Charakterisierung des Grades der Würfeltextur verwendet.

Wege zur Ausführung der Erfindung

Beispiel 1

Technisch reines Nickel mit einem Reinheitsgrad von 99,9 Atom-% Nickel, wird unter Zulegieren von 0,1 Atom-% Molybdän oder 0,1 Atom-% Wolfram in eine Kokille abgegossen.

Der Ingot wird bei 1100°C an die Vierkantabmessung (22 x 22) mm$^2$ gewalzt, homogenisierend geglüht und abgeschreckt. Anschließend wird das Vierkantmaterial spanabhebend überarbeitet, um eine fehlerfreie Oberfläche für die folgende Kaltumformung durch Walzen zu erhalten. Das Kaltwalzen wird mit einem Abwalzgrad von 99,6% Lickenreduktion durchgeführt.

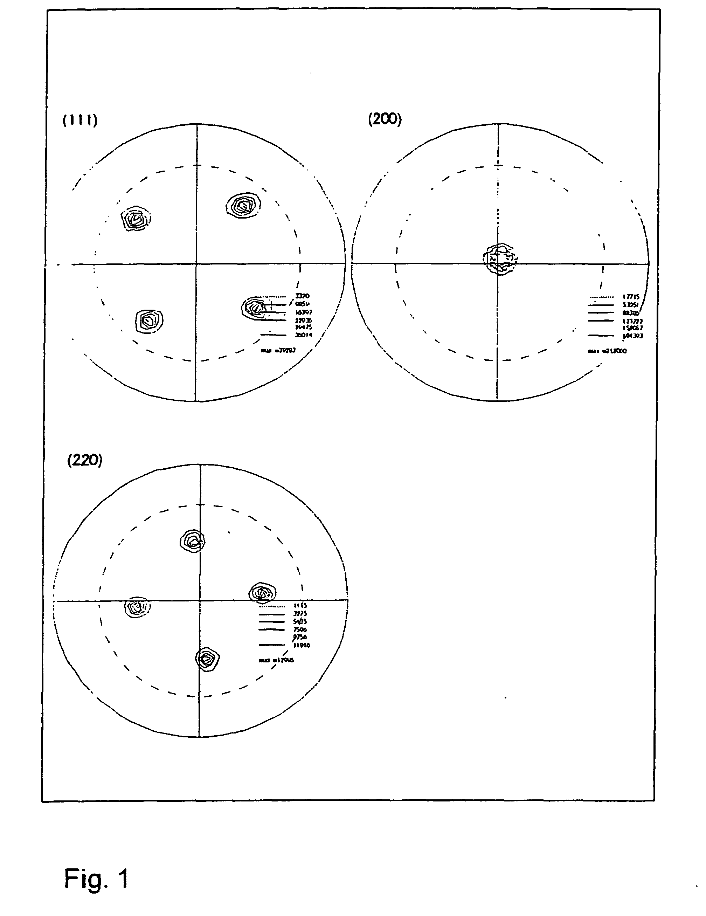

Dar resultierende Nickelband hat eine Dicke von 80 μm und ist hoongradig walztexturiert. Es wird darauf oberhalb von 400°C bis hinauf zu 1150°C einer 30-minütigen Glühbehandlung unterzogen. Das Ergebnis ist eine nahezu vollständige Rekristallisationswürfeltextur wie Fig. 1 und 2 zeigen. Die röntgenographisch gemessenen Intensitäten der (100)-Reflexe im Vergleich zur Intensität der weiteren Reflexhäufungen (Lotgeringfaktor) belegen den deutlichen Legierungseffekt durch Molybdän und Wolfram hinsichtlich Texturverstärkung. Das undotierte Nickelband hat geringere (100)-Intensitäten, die zudem oberhalb von 600°C Glühtemperatur weiter abgeschwächt werden.

Beispiel 2

Technisch reines Nickel mit einem Reinheitsgrad von 99,9 Atom-% Nickel, wird unter Zulegieren von 5 Atom-% Molybdän oder 5 Atom-% Wolfram in eine Kokille abgegossen. Der Ingot wird bei 1100°C an die Vierkantabmessung (22 x 22) mm$^2$ gewalzt, homogenisierend geglüht und abgeschreckt. Anschließend wird das Vierkantmaterial spanabhebend überarbeitet, um eine fehlerfreie Oberfläche für die folgende Kaltumformung durch Walzen zu erhalten. Das Kaltwalzen wird mit einem Abwalzgrad von 99,6% Dickenreduktion durchgeführt.

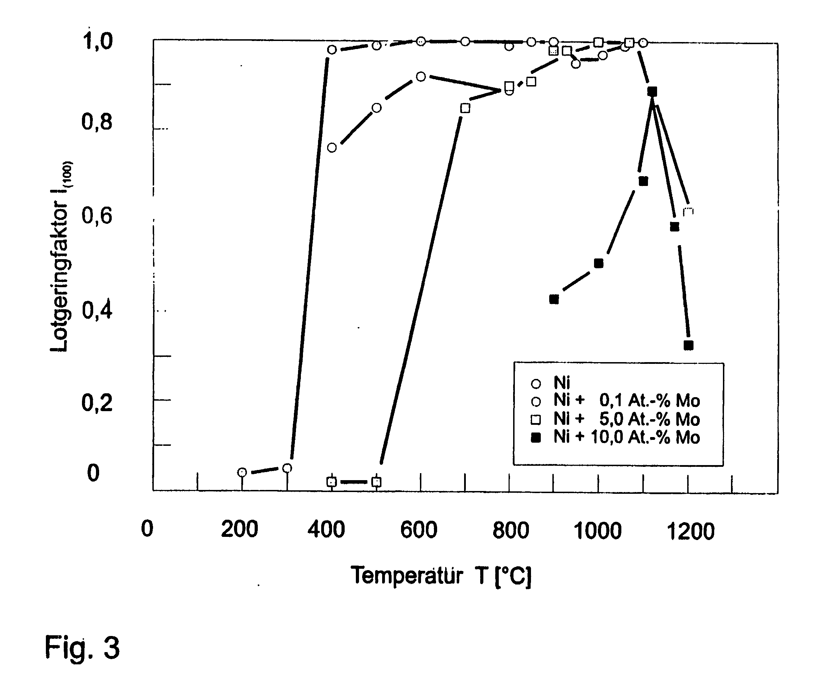

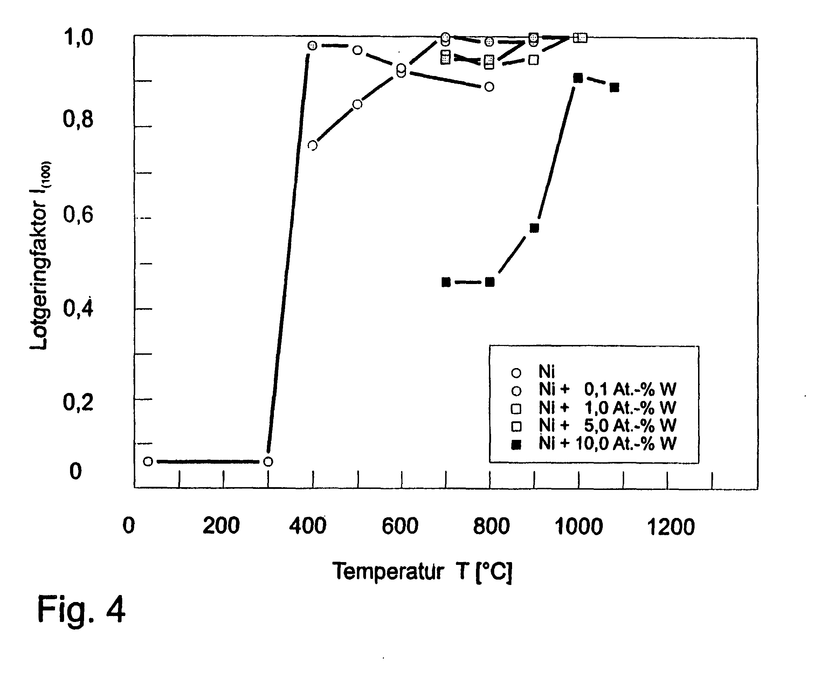

Das resultierende Nickelband hat eine Dicke von 80 μm und ist hochgradig walztexturiert. Es wird darauf oberhalb von 800°C bis hinauf zu 1150°C einer 30-minütigen Glühbehandlung unterzogen. Das Ergebnis ist eine nahezu vollständige Rekristallisationswürfeltextur (Fig. 3 und 4). Die röntgenographisch gemessenen Intensitäten der (100)-Reflexe im Vergleich zur Intensität der weiteren Reflexhäufungen (Lotgeringfaktor) belegen den deutlichen Legierungseffekt durch Molybdän oder Wolfram hinsichtlich der Texturverstärkung. Das undotierte Nickelband hat geringere (100)-Intensitäten, die sich zudem oberhalb von 600°C Glühtemperatur weiter abschwächen. Die Festigkeit dieser Bänder wird infolge der Mischkristallhärtung gegenüber dem unlegierten Nickel auf etwa ein Zweifaches angehoben.

Beispiel 3

Technisch reines Nickel mit einem Reinheitsgrad von 99,9 Atom-% Nickel, wird unter Zulegieren von 4 Atom-% Molybdän und 6 Atom-% Wolfram in eine Kokille abgegossen. Der Ingot wird bei 1100°C an die Vierkantabmessung (22 x 22) mm$^2$ gewalzt, homogenisierend geglüht und abgeschreckt. Anschließend wird das Vierkantmaterial spanabhebend überarbeitet, um eine fehlerfreie Oberfläche für die folgende Kaltumformung durch Walzen zu erhalten. Das Kaltwalzen wird mit einem Abwalzgrad von 99,6% Dickenreduktion durchgeführt.

Das resultierende Nickelband hat eine Dicke von 80 μm und ist hochgradig walztexturiert. Es wird darauf oberhalb von 900°C bis hinauf zu 1200°C einer 30-minütigen Glühbehandlung unterzogen. Das Ergebnis ist eine Rekristallisationstextur, bei der die ehemalige Walzebene und die Würfelfläche des Nickels weitgehend übereinstimmen. Die röntgenographisch gemessenen Intensitäten der (100)-Reflexe im Vergleich zur Intensität der weiteren Reflexhäufungen (Lotgeringfaktor) belegen, dass für diesen Legierungsgehalt an Molybdän oder Wolfram bei Glühtemperaturen im Bereich von 1100°C starke (100)-Intensitäten erzielt werden (Fasertextur).

Durch Optimierung der Bedingungen bei der Kaltumformung und der Glühbehandlung, insbesondere auch erhöhte Glühzeiten, ist eine weitere Texturverstärkung im Sinne der Würfellage zu erreichen. Die Festigkeit dieser Bänder wird infolge der Mischkristallhärtung gegenüber dem unlegierten Nickel auf etwa ein Dreifaches angehoben. Der Ferromagnetismus wird zugleich unterdrückt, da die Curie-Temperatur legierungsbedingt stark abgesenkt wird, beispielsweise für ein mit 9,15 Atom-% Molybdän legiertes Nickelsubstrat in den Bereich von 60 K bis 70 K.

Beispiel 4

Technisch reines Nickel, mit einem Reinheitsgrad von 99,9 Atom-% Nickel, wird unter Zulegieren von 9,5 Atom-% Vanadium und 0,3 Atom-% Wolfram in eine Kokille abgegossen. Die Legierung hat eine chemische Zusammensetzung von $Ni_{90,2}W_{0,3}V_{9,5}$. Der Ingot wird bei 1100°C an die Vierkantabmessung (22 x 22) $mm^2$ gewalzt, homogenisierend geglüht und abgeschreckt. Anschließend wird das Vierkantmaterial spanabhebend überarbeitet, um eine fehlerfreie Oberfläche für die folgende Kaltumformung durch Walzen zu erhalten. Das Kaltwalzen wird mit einem Abwalzgrad von 99,6% Dikkenreduktion durchgeführt.

Das resultierende Nickelband hat eine Dicke von 80 μm und ist hochgradig walztexturiert. Es wird darauf oberhalb von 900°C (bis hinauf zu 1200°C) einer 30-minütigen Glühbehandlung unterzogen. Das Ergebnis ist eine Rekristallisationswürfeltextur.

Durch Optimierung der Bedingungen bei der Kaltumformung und der Glühbehandlung, insbesondere auch erhöhte Glühzeiten, ist eine weitere Texturverstärkung im Sinne der Würfellage zu erreichen. Die Festigkeit dieser Bänder wird infolge der Mischkristallhärtung gegenüber dem unlegierten Nickel auf etwa ein Zwei- bis Dreifaches angehoben. Der Ferromagnetismus wird zugleich unterdrückt, da die Curie-Temperatur legierungsbedingt stark abgesenkt wird, so dass im Temperaturbereich des flüssigen Stickstoffs bei 77 K kein ferromagnetisches Verhalten der texturierten Legierung vorliegt.

**Patentansprüche**

**1.** Metallischer Werkstoff auf Nickelbasis, **dadurch gekennzeichnet, dass** dieser eine Rekristallisationswürfeltextur aufweist und aus einer Nickellegierung besteht, deren Zusammensetzung der allgemeinen Formel

$$Ni_a (Mo_b, W_c)_d M_e$$

entspricht, worin M für V, Cr, und/oder Cu steht, mit

$$a = 100 - (d + e)$$

$$(d + e) \leq 50$$

$$b = 0 - 12$$

$$c = 0 - 12$$

$$d = (b + c) = 0,01 - 12$$

$$e = 0 - 49,9$$

- jeweils in Atom-% -
und mit gegebenenfalls enthaltenen geringen herstellungstechnisch bedingten Verunreinigungen.

**2.** Werkstoff nach Anspruch 1, **dadurch gekennzeichnet, dass** der Gesamtgehalt an Mo und/oder W im Bereich von 0,01 Atom-% bis 0,3 Atom-% oder im Bereich von 3 Atom-% bis 12 Atom-% liegt.

**3.** Werkstoff nach Anspruch 1, **dadurch gekennzeichnet, dass** die Nickellegierung aus technisch reinem Ni und 0,1 Atom-% Mo und/oder W oder aus technisch reinem Ni und 5 Atom-% Mo und/oder W oder aus technisch reinem Ni und 10 Atom-% Mo und/oder W besteht.

**Claims**

**1.** Nickel-based metallic material, **characterized in that** it has a recrystallization cube texture and consists of a nickel alloy, the composition of which corresponds to the general formula

$$Ni_a (Mo_b, W_c)_d M_e$$

where M stands for V, Cr and/or Cu, with

$$a = 100 - (d + e)$$

$$(d + e) \leq 50$$

$$b = 0 - 12$$

$$c = 0 - 12$$

$$d = (b + c) = 0.01 - 12$$

$$e = 0 - 49.9$$

- in each case in atomic % -
and with any minor production-related impurities which may be present.

2. Material according to Claim 1, **characterized in that** the total Mo and/or W content is in the range from 0.01 atomic % to 0.3 atomic % or in the range from 3 atomic % to 12 atomic %.

3. Material according to Claim 1, **characterized in that** the nickel alloy consists of technically pure Ni and 0.1 atomic % of Mo and/or W or of technically pure Ni and 5 atomic % of Mo and/or W or of technically pure Ni and 10 atomic % of Mo and/or W.

**Revendications**

1. Matériau métallique à base de nickel, **caractérisé en ce qu'**il présente une structure cubique de recristallisation et est constitué d'un alliage de nickel, dont la composition correspond à la formule générale

$$Ni_a \, (Mo_b, \, W_c)_d \, M_e$$

dans laquelle M représente V, Cr et/ou Cu, avec

$$a = 100 - (d + e)$$

$$(d + e) \leq 50$$

$$b = 0 - 12$$

$$c = 0 - 12$$

$$d = (b + c) = 0{,}01 - 12$$

$$e = 0 - 49{,}9$$

à chaque fois en % en atome
et contenant le cas échéant des faibles impuretés dues à la technique de fabrication.

2. Matériau selon la revendication 1, **caractérisé en ce que** la teneur totale en Mo et/ou en W se situe dans la plage de 0,01% en atome à 0,3% en atome ou dans la plage de 3% en atome à 12% en atome.

3. Matériau selon la revendication 1, **caractérisé en ce que** l'alliage de nickel est constitué de Ni techniquement pur et de 0,1% en atome de Mo et/ou de W ou de Ni techniquement pur et de 5% en atome de Mo et/ou de W ou de Ni techniquement pur et de 10% en atome de Mo et/ou de W.

## Fig. 1

Fig. 2

EP 1 208 244 B1

Fig. 3

EP 1 208 244 B1

Fig. 4